# EUROPEAN PATENT SPECIFICATION

(11) **EP 0 280 334 B1**
(45) Date of publication and mention of the grant of the patent: **04.05.1994**
(21) Application number: 88102939.1
(22) Date of filing: 26.02.1988
(51) Int. Cl.: H01L 39/24, B28B 3/20

(54) **Method of producing long functional oxide objects**
Verfahren zum Herstellen langer funktioneller Gegenstände aus Oxid
Procédé de fabrication d'objets fonctionnels longs en oxyde

(30) Priority: 26.02.1987 JP 44263/87; 02.04.1987 JP 81830/87
(43) Date of publication of application: 31.08.1988
(73) Proprietor: SUMITOMO ELECTRIC INDUSTRIES LIMITED, Osaka-shi, Osaka 541 (JP)
(72) Inventor: Hayashi, Kazuhiko, Osaka (JP); Okuda, Shigeru, Osaka (JP); Hitotsuyanagi, Hajime, Osaka (JP); Ohkura, Kengo, Osaka (JP)
(74) Representative: KUHNEN, WACKER & PARTNER

(56) References cited:
- EP-A- 0 281 444
- EP-A- 0 281 474
- US-A- 3 372 445
- ZEITSCHRIFT FÜR PHYSIK B - CONDENSED MATTER, vol. 64, 1986, pages 189-193, Springer-Verlag; J.G. BEDNORZ et al.: "Possible high Tc superconductivity in the Ba-La-Cu-O system"
- ELEKTROTECH. & MASCHINENBAU, vol. 101, no. 3, March 1984, pages 108-111; W. GLÄTZLE: "Entwicklung von A15-Supraleitern in Österreich"
- JOURNAL OF THE AMERICAN CERAMIC SOCIETY, vol. 70, no. 12, December 1987, pages C-388 - C-390; I.-W. CHEN et al.: "Texture development in YBa2Cu3Ox by hot extrusion and hot-pressing"
- JAPANESE JOURNAL OF APPLIED PHYSICS, vol. 26, no. 5, May 1987, pages L759-L760; O. KOHNO et al.: "Critical temperature and critical current density of La-Sr-Cu oxide wires"

## Description

The present invention relates to a method of producing a long object formed of functional oxides, in particular to a method of producing a superconductive wire for use in apparatus utilizing a superconductive phenomenon, such as those for a superconductive electric transmission, magnetic levitation train, nuclear fusion and high energy physics, and the like.

### (Prior Art and Problems Thereof)

Said superconductive wire formed of a superconductor, such as NbTi and Nb₃Sn, has been known. Such a superconductive wire is generally obtained by the bronze method.

However, such the superconductive wire has a low critical temperature (T_{c}) and thus it is necessary to maintain its temperature at a superlow temperature by the use of liquid He, so that a problem occurs in that a cost of thermal insulation and cooling is increased. Accordingly, the development of a ceramic superconductor having a high critical temperature and the production of a wire from it have been investigated but since the ceramic superconductor is remarkably brittle and difficult to work, it is generally difficult to turn the ceramic superconductor into a wire.

In addition, recently oxide ceramics having various kinds of function have been developed and methods of producing them have been important techniques. Conventionally, oxides have been produced by molding by the use of a press and then sintering in many cases. If necessary, after molding by the use of a press the temporary sintering has been carried out.

However, such the conventional method has shown a problem in that in the case where it is intended to obtain oxides in the form of long object, the length is limited. That is to say, only the long object having the length of a mold for use in the press-molding can be produced but that having a desired length can not be freely produced. In addition, the conventional method has shown a problem also in that the process is complicated and the productivity is reduced when the long object is produced.

### (Object of the Invention)

Thus, it is an object of the present invention to provide a method of producing a long body having a desired length in high productivity.

It is another object of the present invention to provide a method of producing a superconductive wire in which a ceramic superconductor having a high critical temperature can be turned into a wire by using said method.

### (Measures for Solving the Problems and Operation)

The present invention is below described in detail with reference to the drawings, in which
Fig. 1 is a schematic diagram for describing a conforming apparatus, which is one of frictional drive type extruders used in preferred embodiments of the present invention; and
Fig. 2 is a sectional view describing a method of compounding a stabilizing material in the preferred embodiment of the present invention.

The method according to the present invention is characterized by the features in claim 1 that powders of functional oxides are extruded under the condition that they are heated.

According to the present invention, since the functional oxides are subjected to the extrusion molded to be turned into a long body, the continuous molding is possible, whereby the long object having a desired length can be formed. In addition, the molding is carried out continuously, so that the productivity can be increased and also the cost of production can be reduced.

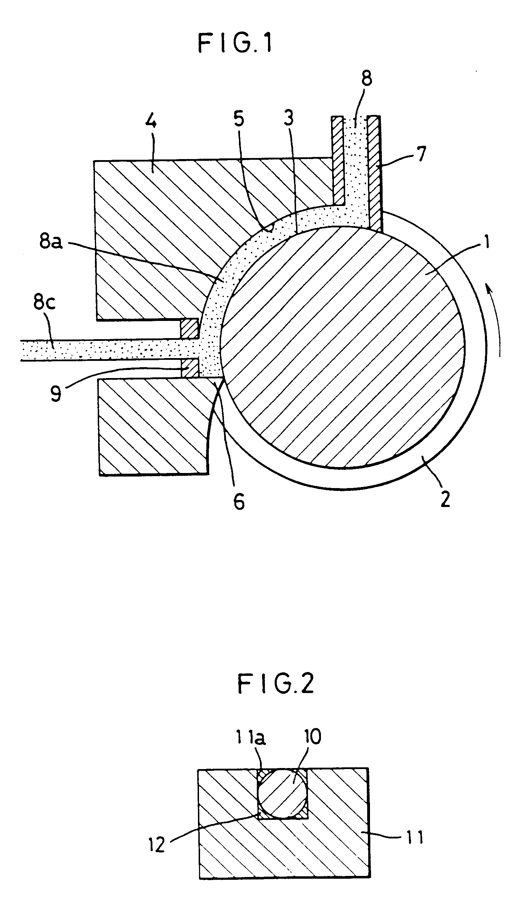

Frictional drive type extruder shown in Fig. 1 is an extruder using a duct defined by a drive wall and a fixed wall having an area smaller than that of the drive wall as a vessel for pressurizing a metal and adapted to send the metal by the friction due to the force of the drive wall of the duct to obtain an extrusion pressure. The frictional drive type extruder shown in Fig. 1 is called a conforming apparatus (see Japanese Patent Laid-Open No. 31859/1972).

In the conforming apparatus shown in Fig. 1 a drive wheel 1 is provided with a groove 2 formed on a circumferential surface thereof, a bottom surface of said groove 2 serving as a drive wall 3. A part of the outside circumference of the drive wheel 1 is engaged with a fixed shoe block 4, a duct being formed between a fixed wall 5 of the fixed shoe block 4 and the drive wall 3.

One end of the duct is closed by a projection 6 of the fixed shoe block 4 and an extrusion die 9 is disposed in the vicinity of one end of the duct. A powder supply means 7 for supplying oxide powders 8 is disposed at another end of the duct.

With the conforming apparatus constructed in the above described manner, the drive wheel 1 is rotated in a direction shown by an arrow in Fig. 1. Upon continuously supplying the powder supply means 7 with the oxide powders 8, the oxide powders 8 is transferred in a direction, in which the drive wheel 1 is rotated,by the friction thereof with the drive wall 3. The oxides powders 8 sent in the duct in such a manner is pressurized and receives an extrusion force. An oxide 8a, which was pressurized, is extruded through an extrusion die 9 to obtain a long oxide object 8c. A temperature of the oxide 8a is heightened by a heat resulting from its friction with the drive wall 3 and the fixed wall 5. In addition, it is pressurized, so that it shows a condition that the oxide powders are strongly joined to each other. Besides, the frictional heat is properly regulated depending upon process conditions, such as an extrusion ratio and extrusion speed, but, if necessary, a separate heating means may be used to heat the duct.

With the frictional drive type extruder represented by the conforming apparatus as above described, functional oxide powders can be extruded under the heated conditions. The oxide powders may be supplied in the form of single kind or combined kinds.

For example, in case of oxides having a laminar perovskite structure, powders of oxides, which already have the laminar perovskite structure, or a powder mixture of oxides blended at such a ratio that the laminar perovuskite structure may be formed by a solid phase reaction may be supplied. Such powder mixture includes a powder mixture comprising at least one kind of oxides of elements of lanthanum series, at least one kind of oxides of elements of the Ia, IIa and IIIa groups in the periodic table, at least one kind of oxides of elements of the Ib, IIb and IIIb groups in the periodic table and at least one kind of oxides of transition elements. Upon supplying the above described conforming apparatus with such powder mixture, the powder mixture is heated by the frictional heat within the duct and extruded under the imitating condition that it is preliminarily sintered. The long oxide object, which is under such preliminarily sintered condition, is machined in the desired form, such as coil, and then additionally heated to bring about the solid phase reaction, whereby an oxide material having the laminar perovskite structure can be obtained. (La₁₋ₓBaₓ)₂CuO_{4-y} and (La₁₋ₓSrₓ)₂CuO_{4-y} [0 < x < 1, 0 ≦ y < 4], Y₁Ba₂Cu₃O₇₋ₓ (0 < x < 1) and the like have been watched with interest recently as the functional oxide having the laminar perovskite structure since they show a comparatively high superconductive critical temperature.

In addition, not only such laminar perovskites but also functional oxides having the perovskite structure, such as barium titanate, can be produced in the same manner by the present invention.

Furthermore, according to a method of producing a superconductive wire in the method of producing the long functional oxide object of the present invention aiming at the achievement of the above described object, a ceramic superconductor having a composition expressed by the following general formula is subjected to the extrusion under the condition that it is heated at about 800°C or more to obtain a wire.

AₐB_{b}C_{c}

wherein A is at least one kind selected from the group consisting of elements of the group Ia in the periodic table, elements of the group of IIa in the periodic table and elements of the group IIIa in the periodic table; B is at least one kind of elements selected from the group consisting of elements of the group of Ib in the periodic table, elements of the group IIb in the periodic table and elements of the group IIIb in the periodic table; C is oxygen, and a, b, c is a ratio of the constituent element, respectively.

The ceramic superconductor expressed by the above described general formula has been discovered anew as one having a high critical temperature and has characteristics that is shows the ductility capable of sufficiently standing up to the extrusion process by heating at about 800°C or more. Therefore, a long and uniform ceramic superconductive wire can be obtained by subjecting this ceramic superconductor to the extrusion with heating at about 800°C or more. Besides, since the reduction in area (a sectional area before the extrusion/a sectional area after the extrusion) can be set at 6 or more, the above described superconductive wire can be efficiently produced.

The above described ceramic superconductor is obtained by sintering raw materials constructing the ceramic superconductor and the like and every raw material containing elements constructing the superconductor can be used in either form of element or compound. The above described element includes elements of the group I, II and III in the periodic table, oxygen, nitrogen, fluorine, carbon, sulfur and the like.

In particular, of the elements of the group I, Li, Na, K, Rb, Cs and the like are included as the elements of the group Ia in the periodic table, and Ag and Au are included as the elements of the group Ib in the periodic table in addition to the above described Cu. In addition, of the elements of the group II in the periodic table, Be, Mg, Ca, Sr, Ba and Ra are included as the elements of the group IIa, and Zn, Cd and the like are included as the elements of the group IIb in the periodic table. Sc, Y, elements of lanthanoid series, such as La, Ce, Gd and Lu, and elements of actinoid series, such as Th, Pa and Cf, are included as the elements of the group IIIa in the periodic table. Besides, Al, Ga, In, Tl and the like are included as the elements of the group IIIb in the periodic table.

Of the above described elements, it is desired that the elements selected from the elements of the group Ib in the periodic table, elements selected from the group IIa, the group IIIa in the periodic table, oxygen and fluorine form the ceramic superconductor. Furthermore, Cu and Ag are preferably used as the elements of the group Ib in the periodic table.

On the other hand, the raw powdery mixture of oxides constructing the ceramic superconductor can be extruded under the condition that it is surrounded by Cu or Cu alloys, too. In this case, the ceramic superconductive wire formed of a composite coated with Cu or Cu alloys, which are suitable as a stabilizing material, can be easily obtained.

In addition, Cu powders or Cu alloy powders having an average particle diameter of 10 µm (microns) or less may be added to the ceramic superconductor. In this case, the workability can be still improved. Besides, the ceramic superconductor obtained by sintering powders of raw materials having an average particle diameter of 10 µm (microns) or less is more preferably used.

Furthermore, the ceramic superconductor is preferably extruded under the semi-molten condition. In particular, in this case,the deformation resistance to the reduction in area is reduced and the workability is remarkably improved. It has been confirmed that even though the ceramic superconductor is semi-molten in such a manner, the superconductive material characteristics are not influenced at all.

In addition, the above described ceramic superconductor is usually heated at 800°C or more by means of a heating means such as a heating furnace and then charged in a hot extruder to be turned into a wire but it can be satisfactorily subjected to the extrusion even though its temperature is lowered several tens of degree after it was taken out of the heating furnace and the like.

The preferred embodiments of the present invention will be below described.

### Example 1

Powdery lanthanum oxide, barium oxide and copper oxide having a purity of 3N grade, an average particle-diameter of 6 µm (microns) and a maximum particle-diameter of 10 µm (microns) were weighed so that La : Ba : Cu might be finally 3 : 1 : 2 and stirred for 3 hours in a ball mill.

The resulting powdery mixture was extruded at 800°C by means of the conforming apparatus shown in Fig. 1. with this apparatus, the powders can be heated by the frictional heat generated by the friction of the powders with a rotating drive wheel 1 but in practice the fixed shoe block 4 and the extrusion die 9 were heated by means of an electric heater so that the temperature of the powdery mixture might reach about 800°C in the stationary operation.

When the extrusion drive wheel having a diameter of 300 mm was rotated at 30 rpm and the die and the shoe block were heated at 400°C, the uniform extrusion can be achieved and the long oxide mixture substance having a diameter of 2 mm was obtained.

The resulting long substance was heated in air at 1,100°C for 2 hours and then gradually cooled (cooled within the furnace) to obtain a long oxide superconductor. A part of the resulting long oxide superconductor was cut out and the superconducting critical temperature T_{c} was measured with passing an transport current of 1 mA through the oxide superconductor by the direct current four-terminal method with the results that an electric resistance amounted to zero at 42K and the temperature transition width was about 2K.

### Example 2

Powdery yttrium oxide (Y₂O₃), barium carbonate (BaCO₃) and copper oxide having a purity of 3N grade and an average particle-diameter 3 µm (microns) were weighed so that Y : Ba : Cu might be 1 : 2 : 3 and blended for 3 hours in a ball mill. Subsequently, the resulting mixture was spread over an alumina dish and baked for 12 hours at 900°C in the air. The baked mixture was gradually cooled within the furnace to absorb oxygen, whereby a superconductive phase mainly comprising an orthorhombic structure was obtained. Subsequently, this operation was repeated twice to obtain a high quality superconductive powder which appears to be almost perfectly formed of the superconductive phase on the basis of the measurement of magnetic susceptibility. The resulting high quality superconductive powders were pressed at a pressure of 1000 kg/cm² (1 ton/cm²) to obtain a columnar compressed powdery body having a diameter of 20 mm and a length of 50 mm.

The resulting columnar compressed powdery body was covered with an oxygenfree copper tube having an inside diameter of 21 mm and an outside diameter of 32 mm and with closing the front and rear ends by a copper disk to obtain a billet. The resulting billet was heated at 850°C and then charged in a container of a hot extrusion press of 5 x 10⁴ kg (50 tons) preliminarily heated at 500°C to be extruded in an outside diameter of 2 mm, whereby a superconducting wire clad with Cu having a length of 6 m was obtained. The extrusion speed was 1 mm/min.

In addition a device was taken so that the material might be extruded onto a heated iron plate to be gradually cooled in order to prevent the material from rapidly cooling after extruded.

The ceramic superconducting wire obtained in the above described manner showed an excellent quality, that is, it hardly showed cracks and other defects.

In addition, copper as the stabilizing material could be easily integrated. the critical temperature T_{c} of the resulting material was measured with passing a transport current of 1 mA through the material by the direct current four-terminal method in the same manner as in Example 1 with the results that an electric resistance amounted to zero at 87K and the temperature transition width was about 5K.

A long oxide body obtained in the above described Example 1 and Example 2 is a superconductor, so that it is useful as a long functional oxide object. However, in many cases, in general conductive metals, such as copper and aluminium, are used as a stabilizing material for the superconducting wire. Accordingly, the stabilizing material having a low electric resistance is preferably used also for the long oxide object showing the superconductivity obtained in Example 1 and Example 2, similarly.

However, since external copper in Example 2 is treated at high temperatures, it is partially turned into black copper oxide to reduce a value for commercial products and there is room for improving also the superconductive characteristics such as critical current density. Accordingly, the present inventors made progress the process using the superconducting wire according to Example 2.

That is to say, dirty copper on the surface of copper-clad ceramic superconducting wire was dissolved with nitric acid (1 : 1) and then sintered for 6 hours at 950°C in air followed by annealing for 12 hours at 700°C in an atmosphere of oxygen of 1 atmospheric pressure. Subsequently, it was cooled within the furnace to be gradually cooled.

The superconductive characteristics of the resulting superconductor was measured with the results that the critical temperature was risen to 91K, also the transition width being narrowed to 2K or less, and the critical current density being 200 A/cm² at 77K.

A method of composing the stabilizing materials to the resulting superconductor is not specially limited but for example the long oxide object is soldered to a copper block cable. This method will be below described with reference to Fig. 2.

Fig. 2 is a sectional view showing a condition under which the copper block cable 11 is soldered to the long oxide object 10. The copper block cable 11 is provided with a groove 11a, in which the long oxide object 10 is embedded, the long oxide object 10 being soldered to the copper block cable 11 by means of a solder 12 within said groove 11a. The long oxide object 10 can be soldered to the copper block cable 11 by dipping the former in a soldering bath together with the latter and then pulling up. In this time, the long oxide object 10 is dipped in the soldering bath under the condition that it is put in the groove 11a of the copper block cable 11. the solder 12 exists in the groove 11a of the copper block cable 11 when pulled out of the soldering bath and cooled to be solidified, whereby the long oxide object 10 is soldered to the copper block cable 11. In addition, it was necessary that the surface of the long oxide object is preliminarily subjected to a surface treatment by the ultrasonic soldering to improve the wetness to the solder.

In addition, also other conductive metals, such as aluminium, can be used as the metallic block cable instead of the illustrated copper.

### Example 3

Powdery Bi₂O₃, SrCO₃ , CaO and CuO having a purity of 3N grade and an average particle-diameter of 5 µm (microns) or less were weighed so that a ratio Bi : Sr : Ca : Cu might be 1 : 1 : 1 : 2 and the blended and pulverized in a mortar made of agate. The resulting powdery mixture was baked for 6 hours at 800°c in air and then pressed in a metallic mold made of carbide alloys at a pressure of 1000 kg/cm² (1 ton/cm²) to obtain a columnar compressed powdery body having a diameter of 20 mm and a length of 50 mm.

The resulting columnar compressed powdery body was covered with an oxygenfree copper tube having an inside diameter of 20.5 mm and an outside diameter of 35 mm and with closing the front and rear ends by means of a copper disk to obtain a billet.

The resulting billet was heated at 800°C and then charged in a container of a hot extrusion press of 5 x 10⁴ kg (50 tons) preliminarily heated at 500°C followed by extruding in an outside diameter of 3 mm to obtain a Cu-clad superconducting wire having a length of 3 m. Although a measure for gradually cooling after extruded was not taken in Example 3 differently from Example 2, the electric resistance amounted to zero at the critical temperature of 81K and the critical current density at 77K was 20 A/mm².

Since the extrusion temperature was low in comparison with that in Example 2 and the extruded superconducting wire was chilled, the surface condition of copper was good and thus it could be used as the stabilizing material as it was.

This material was slightly improved in superconductive characteristic by repeating the baking process, which was carried out for 6 hours at 800°C in air, twice to obtain a product of industrially good quality but the excessive repetition of such the baking process did not lead to any special difference.

### (Effects of the Invention)

As above described, according to a method of the present invention, oxides having various kinds of function can be easily produced in the form of long object. According to the present invention, the long object is continuously extrusion-molded, so that the length of the long object can be freely designed. In addition, the production process can be simplified in comparison with the conventional ones, so that the productivity can be increased and the cost of production can be reduced.

Besides, according to the method of producing a superconducting wire of the present invention, the ceramic superconductor having the composition expressed by said general formula is extruded with heating at about 800°C or more under the condition that the excellent workability is secured, so that a unique effect is exhibited in that the ceramic superconductive wire can be efficiently produced without forming cracks, breakages and the like.

Furthermore, if the present invention is intended to carry out at low temperatures of 700°C or less, a uniform long body is difficult to obtain due to the bad workability of the oxide powders but if the present invention is carried out at temperatures of about 800°C or more, the excellent extrudability can be obtained. In addition, if organic binders and pastes are added to the oxide powders, the extrudability of 700°C or less can be obtained but the function, such as excellent superconductive characteristics, can not be obtained due to the remaining of the binders as impurities.

Besides, although a frictional drive type extruder was used in the above described Example 1 and a usual hot extruder in the above described Examples 2, 3, the extrusion is not limited to these methods. Various kinds of extruder, such as a screw extruder, rear extruder and hot hydrostatic extruder, can be used.

## Claims

1. A method of manufacture a ceramic superconductive wire,
**characterized in that**
a powdery mixture of oxides having a composition expressed by a general formula AₐB_{b}C_{c}, wherein A is at least one kind selected from the group consisting of elements of the groups Ia, IIa and IIIa in the periodic table forming the powdery mixture; B is at least one kind selected from the group consisting of elements of the groups Ib, IIb and IIIb in the periodic table; C is oxygen; and a, b, c is a ratio of a constituent element, respectively;
is extruded in the form of a wire under the condition that it is heated at temperatures of 800° C or more, the heat, at least partly, being generated by frictional heat, and the extrusion force being generated by frictional force; and
that the wire is subjected to a second heating treatment to obtain an oxide material having a perowskite structure.

2. A method according to claim 1, wherein the wire, which was subjected to the heating treatment, is immersed in a solder bath together with a metallic block cable and then pulled up from the solder bath to solder the wire to said metallic block cable.

3. A method according to claim 1, wherein a mixture comprising Cu powders or Cu alloy powders having an average particle-diameter of 10 µm (microns) or less is added to the ceramic superconductor.

4. A method according to claim 1 and/or 3, wherein the ceramic superconductor is obtained by sintering powdery raw materials having an average particle-diameter of 10 µm (microns) or less.

5. A method according to claim 1 to 4, wherein the ceramic superconductor is extruded under the condition that it is semimolten.

## Patentansprüche

1. Ein Verfahren zur Herstellung eines keramischen supraleitenden Drahtes,
**dadurch gekennzeichnet, daß**
eine pulvrige Mischung aus Oxiden mit einer Zusammensetzung, ausgedrückt durch eine allgemeine Formel AₐB_{b}C_{c}, worin A wenigstens ein Mitglied, ausgewählt aus der Gruppe bestehend aus Elementen der Gruppen Ia, IIa und IIIa des Periodensystems, welche die pulvrige Mischung bilden, ist, B wenigstens ein Mitglied, ausgewählt aus der Gruppe bestehend aus Elementen der Gruppen Ib, IIb und IIIb des Periodensystems ist, C Sauerstoff ist und a, b, c ein Anteil eines jeden Bestandteilelements ist;
in der Form eines Drahtes unter der Bedingung ausgezogen wird, daß dieser bei Temperaturen von 800°C oder darüber erwärmt wird, wobei die Wärme, wenigstens teilweise, durch Reibungswärme erzeugt wird, und die Ziehkraft durch Reibungskraft erzeugt wird; und
daß der Draht einer zweiten Wärmebehandlung unterworfen wird, um ein Oxidmaterial mit einer Perowskitstruktur zu erhalten.

2. Ein Verfahren gemäß Anspruch 1, worin der Draht, welcher der Wärmebehandlung unterworfen wurde, zusammen mit einem metallischen Blockkabel in ein Lötbad eingetaucht wird und dann aus dem Lötbad herausgezogen wird, um den Draht an das genannte metallische Blockkabel zu löten.

3. Ein Verfahren gemäß Anspruch 1, worin eine Mischung, welche Cu-Pulver oder Cu-Legierungspulver mit einem Durchschnitts-Teilchendurchmesser von 10 µm (Mikrometer) oder weniger umfaßt, zu dem keramischen Supraleiter zugegeben wird.

4. Ein Verfahren gemäß Anspruch 1 und/oder 3, worin der keramische Supraleiter durch Sintern von pulvrigen Rohmaterialien mit einem Durchschnitts-Teilchendurchmesser von 10 µm (Mikrometer) oder weniger erhalten wird.

5. Ein Verfahren gemäß Anspruch 1 bis 4, worin der keramische Supraleiter unter der Bedingung ausgezogen wird, daß er halbgeschmolzen ist.

## Revendications

1. Procédé de fabrication d'un fil supraconducteur en une matière céramique, procédé caractérisé en ce que
- l'on soumet un mélange pulvérulent d'oxydes ayant une composition exprimée par la formule générale AₐB_{b}C_{c} (dans laquelle A représente au moins un genre choisi dans l'ensemble consistant en des éléments des groupes Ia, IIa, IIIa du tableau périodique formant le mélange pulvérulent; B représente au moins un genre choisi dans l'ensemble consistant en des éléments des groupes Ib, IIb, et IIIb du tableau périodique; C représente l'oxygène; et a, b et c représentent chacun, respectivement, un taux ou rapport d'un élément constituant);
- à une extrusion pour obtenir un produit sous forme de fil, par chauffage à des températures égales ou supérieures à 800°C, la chaleur étant au moins partiellement engendrée par de la chaleur de frottement, et la force d'extrusion étant engendrée par une force de frottement, et
- l'on soumet le fil à un second traitement de chauffage pour obtenir une matière formée d'oxydes ayant une structure de perowskite.

2. Procédé selon la revendiation 1, dans lequel le fil, qui a été soumis au traitement de chauffage, est immergé dans un bain de soudure avec un câble en forme de bloc métallique et est ensuite tiré du bain de soudure pour souder le fil audit câble à bloc métallique.

3. Procédé selon la revendication 1 dans lequel on ajoute à la matière céramique supraconductrice un mélange comprenant des poudres de Cu ou des poudres d'alliage de Cu ayant un diamètre particulaire moyen égal ou inférieur à 10 µm.

4. Procédé selon la revendication 1 et/ou 3, dans lequel la matière céramique supraconductrice est obtenue par frittage de matières premières pulvérulentes ayant un diamètre particulaire moyen égal ou inférieur à 10 µm (microns).

5. Procédé selon l'une des revendications 1 à 4, dans lequel la matière céramique supraconductrice est extrudée à l'état semi-fondu.
